# EUROPÄISCHE PATENTSCHRIFT

(11) **EP 4 324 021 B1**
(45) Veröffentlichungstag und Bekanntmachung des Hinweises auf die Patenterteilung: **04.11.2026**
(21) Anmeldenummer: 22722203.1
(22) Anmeldetag: 11.04.2022
(51) Int. Cl.: H10P 14/20, H10P 50/00

(54) **VERFAHREN ZUR PRÄPARATION EINES GERMANIUMSUBSTRATS FÜR EIN EPITAKTISCHES AUFWACHSEN EINER GERMANIUMSCHICHT**
METHOD OF PREPARING A GERMANIUM SUBSTRATE FOR EPITAXIAL GROWTH OF A GERMANIUM LAYER
PROCÉDÉ DE PRÉPARATION D'UN SUBSTRAT DE GERMANIUM POUR LA CROISSANCE ÉPITAXIALE D'UNE COUCHE DE GERMANIUM

(30) Priorität: 12.04.2021 DE 102021108992
(43) Veröffentlichungstag der Anmeldung: 21.02.2024
(73) Patentinhaber: Fraunhofer-Gesellschaft zur Förderung der angewandten Forschung e.V., 80686 München (DE)
(72) Erfinder: JANZ, Stefan, 79110 Freiburg (DE); SCHREIBER, Waldemar, 79110 Freiburg (DE)
(74) Vertreter: LBP Lemcke, Brommer & Partner Patentanwälte mbB
(86) Internationale Anmeldenummer: PCT/EP2022/059591
(87) Internationale Veröffentlichungsnummer: WO 2022/218905

(56) Entgegenhaltungen:
- DE-B3- 102009 004 560
- ARVINTE ROXANA ET AL: "Epitaxial lift-off process for III-V solar cells by using porous germanium for substrate re-use", 2020 47TH IEEE PHOTOVOLTAIC SPECIALISTS CONFERENCE (PVSC), IEEE, 15 June 2020 (2020-06-15), pages 1976 - 1981, XP033870238, DOI: 10.1109/PVSC45281.2020.9301028
- BOUCHERIF ABDERRAOUF ET AL: "Mesoporous germanium morphology transformation for lift-off process and substrate re-use", APPLIED PHYSICS LETTERS, AMERICAN INSTITUTE OF PHYSICS, 2 HUNTINGTON QUADRANGLE, MELVILLE, NY 11747, vol. 102, no. 1, 7 January 2013 (2013-01-07), pages 11915 - 11915, XP012168696, ISSN: 0003-6951, [retrieved on 20130111], DOI: 10.1063/1.4775357

## Beschreibung

Die Erfindung betrifft ein Verfahren zur Präparation eines Germaniumsubstrats für ein epitaktisches Aufwachsen einer Germaniumschicht gemäß Anspruch 1.

Bei der Herstellung von Halbleiterbauelementen, insbesondere bei der Herstellung photovoltaischer Solarzellen werden häufig Germaniumschichten verwendet. Eine gängige Vorgehensweise ist das Erzeugen der Germaniumschicht mittels Epitaxie auf einem Germaniumsubstrat. Hierbei ist es vorteilhaft, zwischen dem nicht-porösen Germaniumsubstrat und der epitaktisch aufgebrachten Germaniumschicht eine poröse Schichtstruktur anzuordnen, um in der Germaniumschicht unabhängig von dem Germaniumsubstrat funktionierende Halbleiterbauelemente auszubilden, insbesondere, um die Germaniumschicht von dem Germaniumsubstrat zu lösen.

Aus A. Boucherif, et al, "Mesoporous Germanium Morphology Transformation for Lift-off Process and Substrate Re-Use" DOI 10.1063/1.4775357, ist die Ausbildung einer porösen Struktur an einer Bearbeitungsseite eines Germaniumsubstrats, das epitaktische Aufwachsen einer Germaniumschicht an der Bearbeitungsseite, das Ablösen der Germaniumschicht und die Wiederverwendung des verbleibenden Germaniumsubstrats bekannt.

Untersuchungen der Anmelderin zeigen, dass die vorbekannten Prozesse Nachteile in der Prozesssicherheit und/oder der Qualität der erzeugten Germaniumschicht aufweisen, insbesondere Mängel in der elektronischen Qualität der erzeugten Germaniumschicht und/oder eine hohe Bruchgefahr beim Ablösen der Germaniumschicht.

Es besteht somit ein Bedarf, Germaniumschichten epitaktisch auf einem Germaniumsubstrat mit hoher elektronischer Güte und hoher Prozesssicherheit, insbesondere geringer Bruchgefahr beim Ablösen zu erzeugen.

Der vorliegenden Erfindung liegt daher die Aufgabe zugrunde, ein Verfahren zur Herstellung einer verbesserten Germaniumsubstratstruktur für ein epitaktisches Aufwachsen einer Germaniumschicht zur Verfügung zu stellen.

Gelöst ist diese Aufgabe durch ein Verfahren zur Präparation eines Germaniumsubstrats für ein epitaktisches Aufwachsen einer Germaniumschicht gemäß Anspruch 1. Vorteilhafte Ausgestaltungen finden sich in den abhängigen Ansprüchen.

Das erfindungsgemäße Verfahren zur Präparation eines Germaniumsubstrats für ein epitaktisches Aufwachsen einer Germaniumschicht weist folgende Verfahrensschritte auf:
A. Bereitstellen eines Germaniumsubstrats mit einer Bearbeitungsseite und einer der Bearbeitungsseite gegenüberliegenden Rückseite und elektrochemisches Bearbeiten zumindest der Bearbeitungsseite des Germaniumsubstrats mit zumindest den Bearbeitungsschritten:
A.0 Passivierung der Bearbeitungsseite, wobei die Bearbeitungsseite als Kathode polarisiert wird,
A.1 Ätzen der Bearbeitungsseite, wobei die Bearbeitungsseite alternierend in einem Anodenpuls als Anode und in einem Kathodenpuls als Kathode polarisiert wird,
A.2 Elektrochemisches Passivieren der Bearbeitungsseite des Germaniumsubstrats wobei die Bearbeitungsseite als Kathode polarisiert wird;
A.3 Ätzen der Bearbeitungsseite, wobei die Bearbeitungsseite alternierend in einem Anodenpuls als Anode und in einem Kathodenpuls als Kathode polarisiert wird;
B. Reorganisieren der Bearbeitungsseite, wobei eine Erwärmung des Germaniumsubstrats auf eine Temperatur größer 500°C erfolgt.

Die Verfahrensschritte werden in der oben aufgeführten Reihenfolge durchgeführt, wobei es im Rahmen der Erfindung liegt, weitere Zwischenschritte einzufügen.

Elektrochemische Verfahrensschritte, bei welchen die Polarität während der Bearbeitung nicht geändert wird, werden als unipolare Verfahrensschritte bezeichnet. Bevorzugt ist der vorangehend beschriebene Verfahrensschritt A.2 und Verfahrensschritt A.0 als unipolarer Verfahrensschritt ausgebildet.

Verfahrensschritte mit Wechseln der Polarität werden als bipolare Verfahrensschritte bezeichnet. Bevorzugt sind die vorangehend beschriebenen Verfahrensschritte A.1 und A.3, weiter bevorzugt zumindest einer der nachfolgend in vorteilhaften Ausführungen beschriebenen Verfahrensschritte A.1A und A.4, bevorzugt beide Verfahrensschritte als bipolare Verfahrensschritte ausgebildet.

Das erfindungsgemäße Verfahren weist somit mehrere Bearbeitungsschritte auf, welche als elektrochemische Bearbeitungsschritte ausgebildet sind. Hierbei erfolgt ein Bearbeiten der Bearbeitungsseite, wobei ein Ätzen (insbesondere in den Verfahrensschritten A.1 und A.3) mittels elektrochemisch ausgelöstem Abtrag von Germaniumatomen, oder ein elektrochemisches Passivieren (insbesondere in Verfahrensschritt A.0 und A.2) insbesondere mittels Terminierung der freien Germaniumbindungen an der Oberfläche durchgeführt wird. Dies trifft auch für die nachfolgend als vorteilhafte Weiterbildung genannten Verfahrensschritten zu, welche ein Ätzen oder ein Passivieren betreffen. Den Verfahrensschritten zum Ätzen oder Passivieren der Bearbeitungsseite ist gemeinsam, dass für den Bearbeitungsvorgang ein elektrisches Feld notwendig ist.

Vor Verfahrensschritt A.1 erfolgt in einem Verfahrensschritt A.0 eine Passivierung einer Bearbeitungsseite des Germaniumsubstrats, wobei die Bearbeitungsseite als Kathode polarisiert wird. Hierdurch ergibt sich der Vorteil, dass die Oberflächenatome, an Stellen wo dies möglich ist, mit passiviert werden, insbesondere mit einem oder mehreren Elementen aus der Ätzlösung, insbesondere mit Wasserstoff.

Durch die Kombination von elektrochemischen Ätzprozessen, die bipolar ausgeführt werden, mit unipolaren Passivierprozessen kann die Entstehung der porösen Einzelschichten wesentlich besser voneinander getrennt werden. Dadurch entstehen Schichtstapel, wobei sich die Einzelschichten in ihrer Porosität stark voneinander unterscheiden. In der Reorganisation kommt es dann zu einer strukturellen Umordnung die zu einer Verstärkung dieser Porositätsunterschiede führt.

In einer vorteilhaften Ausführungsform wird mittels Verfahrensschritt A.1 eine dendritische Schicht, bevorzugt mit einer Porosität im Bereich 5% bis 15% und einer Dicke im Bereich 200 nm bis 1,5 µm an der Bearbeitungsseite erzeugt.

Die dendritische Struktur bietet den Vorteil, dass benachbarte Dendrite einen ausreichend großen Abstand besitzen, sodass diese wirksam während der Durchführung von A.2 passviert werden können. Damit geht einher, dass die Substratoberfläche während Verfahrensschritt A.3 nicht oder nur geringfügig verändert wird.

In einer weiteren vorteilhaften Ausführungsform entspricht in Verfahrensschritt A.1 die Pulsdauer des Anodenpulses im Wesentlichen, insbesondere genau der Länge des Kathodenpulses.

Hierdurch wird gewährleistet, dass bereits gebildete Dendrite in ihrer Ausbreitung nicht frühzeitig unterbrochen werden und ein Ätzgeschehen orthogonal zur Substratoberfläche erfolgt.

In einer weiteren vorteilhaften Ausführungsform wird mittels Verfahrensschritt A.1A eine Schicht mit einer Dicke im Bereich 0,5 µm bis 2 µm, insbesondere im Bereich 1,4 µm bis 1,6 µm und einer Porosität im Bereich 5% bis 15% erzeugt.

Hierdurch bleibt die bereits existierende Schicht weitgehend unverändert und dennoch wird die Dicke der porösen Schicht erhöht. Darüber hinaus wird die Porosität des neu entstehenden porösen Bereichs etwas verringert gegenüber der bereits bestehenden porösen Schicht.

Wesentlich ist zudem, dass Verfahrensschritt A.1 für eine Zeitdauer im Bereich 15 Minuten bis 2 Stunden, bevorzugt im Bereich 15 Minuten bis 30 Minuten durchgeführt.

Hierdurch wird die Dicke der weiter unten beschriebenen geschlossenen Wachstumsvorlageschicht mitbestimmt. Untersuchungen zeigen, dass die vorgenannten Prozessparameter eine qualitativ hochwertige geschlossene Wachstumsvorlageschicht ermöglichen.

Wesentlich ist zudem, dass in Verfahrensschritt A.1 die Ätzstromdichte im Bereich 0,1 mA/cm² bis 1 mA/cm²liegt, In einer weiteren vorteilhaften Ausführungsform liegt in Verfahrensschritt A.1 die Ätzstromdichte im Bereich 0,15 mA/cm² bis 0,75 mA/cm².

Hierdurch wird sichergestellt, dass einerseits die Dichte der Anätzpunkte die Rauigkeit der Oberfläche nicht unvorteilhaft verändert, andererseits soll dadurch sichergestellt werden, dass die entstehenden Dendrite nicht zu nah aneinander kommen.

In einer weiteren vorteilhaften Ausführungsform wird Verfahrensschritt A.2 für eine Zeitdauer im Bereich 5 Minuten bis 20 Minuten, insbesondere im Bereich 4 Minuten bis 12 Minuten durchgeführt.

Hierdurch wird eine gleichmäßige Passivierung erzielt. In einer vorteilhaften Weiterbildung werden die freien Germaniumbindungen an der Oberfläche durch Wasserstoff passiviert, insbesondere bevorzugt durch die Verwendung von Flusssäure (HF) und/oder Wasser zur Passivierung.

In einer weiteren vorteilhaften Ausführungsform beträgt in Verfahrensschritt A.2 die Stromdichte im Bereich 0,5 mA/cm² bis 1,5 mA/cm², insbesondere etwa 1 mA/cm².

Hierdurch wird es insbesondere zu Beginn des Prozesses eine lokale Entwicklung molekularen Wasserstoffs vermieden oder zumindest verringert und eine gleichmäßige Wasserstoff-Passivierung von Hydroxid-passivierten Germaniumoberflächenatomen begünstigt.

Der Verfahrensschritt A.3 wird für eine Zeitdauer im Bereich 3 Minuten bis 1 Stunde, insbesondere im Bereich 5 Minuten bis 45 Minuten durchgeführt.

Hierdurch bildet sich eine Pufferschicht am Übergang zum Festkörper entsprechend der Form und der Eigenschaften der sich darüber befindenden porösen Strukturen.

In Verfahrensschritt A.3 liegt die Ätzstromdichte im Bereich 2 mA/cm² bis 15 mA/cm², insbesondere im Bereich 2,5 mA/cm² bis 5 mA/cm². Vorteilhafterweise liegt die Dauer eines Anodenpulses im Bereich 0,5 s bis 1 s. Bevorzugt liegt die Dauer eines Anodenpulses im Bereich 0,5 s bis 2,5 s.

Hierdurch wird die Porosität der entstehenden Schicht gesteigert. Des Weiteren wird hierdurch begünstigt, dass die bereits existierenden porösen Schichten nicht verändert (angegriffen) werden.

In Verfahrensschritt A.3 ist die Dauer des Anodenpulses kürzer als die Dauer des Kathodenpulses. Hierdurch ergibt sich der Vorteil, dass eine Zerstörung, insbesondere der für die Epitaxie wichtigen Bereiche minimiert wird.

In einer weiteren vorteilhaften Ausführungsform erfolgt in Verfahrensschritt B eine Erwärmung auf eine Temperatur im Bereich 600°C bis 800°C.

In diesem Prozessschritt wird die thermische Energie bereitgestellt, welche zu einer Diffusion der freien Germaniumbindungen entlang der Oberflächen oder im Volumen führt, die eine Umordnung der porösen Strukturen zur Folge hat.

Bevorzugt erfolgt in Verfahrensschritt B eine Erwärmung für eine Zeitdauer größer oder gleich 15 Minuten, insbesondere im Bereich 15 Minuten bis 1,5 h.

Hierdurch wird eine Umordnung erzielt, die zu Strukturen führt, welche im energetischen Gleichgewicht sind und z.B. die Kristallebenen in den Poren nachbilden (z.B. Porenwände in der <111> Orientierung).

Bevorzugt wird Verfahrensschritt B in einer Wasserstoffatmosphäre und/oder Argonatmosphäre durchgeführt.

Wasserstoff und/oder Argon führen zu einem Abtrag des oberflächlichen Oxides und führen dadurch zu freien Germaniumbindungen die wiederum diffundieren und sich damit umordnen können.

Die Pulsdauer in Verfahrensschritt A.1 und A.3 ist jeweils kleiner 10 Sekunden, bevorzugt kleiner 5 Sekunden, besonders bevorzugt kleiner 2 Sekunden, insbesondere kleiner 1 Sekunden. Für die angegebenen Verfahrensschritte ist somit bevorzugt die Pulsdauer jedes Anodenpulses und jedes Kathodenpulses jeweils kleiner als die angegebene Obergrenze. Hierdurch ergibt sich der Vorteil, dass ein zeiteffizientes Verfahren erzielt wird.

Um eine ausreichende Passivierungswirkung zur erzielen, ist es vorteilhaft, dass Verfahrensschritt A.0 und/oder Verfahrensschritt A.2, bevorzugt Verfahrensschritt A.0 und Verfahrensschritt A.2 für eine Zeitdauer größer 10 Sekunden, insbesondere größer 15 Sekunden, bevorzugt größer 20 Sekunden durchgeführt wird, insbesondere,
dass Verfahrensschritt A.0 für eine Zeitdauer im Bereich 10 Sekunden bis 30 Sekunden, insbesondere im Bereich 15 Sekunden bis 25 Sekunden durchgeführt wird.

Insbesondere ist es vorteilhaft, dass die Kathodenpulsdauer bei Passivierungsschritt A.0 größer ist als die Kathodenpulsdauer bei Verfahrensschritt A.1, bevorzugt, dass die Kathodenpulsdauer bei Passivierungsschritt A.0 um zumindest einen Faktor 1,5, bevorzugt um zumindest einen Faktor 2, insbesondere um zumindest einen Faktor 5 größer ist als die Kathodenpulsdauer bei Verfahrensschritt A.1. Hierdurch wird einerseits eine gute Passivierung in Verfahrensschritt A.0 und andererseits eine gute Porosizierung in Verfahrensschritt A.1 erzielt wird.

Weiterhin ist es vorteilhaft, dass die Kathodenpulsdauer bei Passivierungsschritt A.2 größer ist als die Kathodenpulsdauer bei Verfahrensschritt A.3, bevorzugt, dass die Kathodenpulsdauer bei Passivierungsschritt A.2 um zumindest einen Faktor 1,5, bevorzugt um zumindest einen Faktor 2, insbesondere um zumindest einen Faktor 5 größer ist als die Kathodenpulsdauer bei Verfahrensschritt A.3. Hierdurch wird einerseits eine gute Passivierung in Verfahrensschritt A.2 und andererseits eine gute Porosizierung in Verfahrensschritt A.3 erzielt wird.

In einer weiteren vorteilhaften Ausführungsform wird Verfahrensschritt A.0 Verfahrensschritt A.0 und/oder Verfahrensschritt A.2, bevorzugt Verfahrensschritt A.0 und Verfahrensschritt A.2 für eine Zeitdauer größer 10 Sekunden, insbesondere größer 15 Sekunden, bevorzugt größer 20 Sekunden durchgeführt wird, insbesondere,
dass Verfahrensschritt A.0 für eine Zeitdauer im Bereich 10 Sekunden bis 30 Sekunden, insbesondere im Bereich 15 Sekunden bis 25 Sekunden durchgeführt wird..

Hierdurch wird eine gleichmäßige Passivierung erzielt. In einer vorteilhaften Weiterbildung werden die freien Germaniumbindungen an der Oberfläche durch Wasserstoff passiviert, insbesondere bevorzugt durch die Verwendung von Flusssäure (HF) und/oder Wasser zur Passivierung.

Vorteilhafterweise erfolgt zwischen Verfahrensschritt A.1 und A.2 in einem Verfahrensschritt A.1A ein Ätzen der Bearbeitungsseite mit einer gegenüber Verfahrensschritt A.1 erhöhten Ätzstromdichte, wobei die Bearbeitungsseite alternierend in einem Anodenpuls als Anode und in einem Kathodenpuls als Kathode polarisiert wird und die Anodenpulsdauer kürzer als die Kathodenpulsdauer ist.

Hierdurch ergibt sich der Vorteil, dass einerseits die bereits existierende poröse Schicht vor einem Ätzangriff geschützt wird und andererseits eine zusätzliche Schicht niedrigerer Porosität entsteht. Diese ist wichtig, um im Reorganisieren in Verfahrensschritt B einen Bereich zu schaffen, der nicht als Diffusionssenke wirkt.

In einer weiteren vorteilhaften Ausführungsform beträgt in Verfahrensschritt A.1A die Pulsdauer des Anodenpulses im Bereich 30% bis 70%, bevorzugt im Bereich 40% bis 60%, insbesondere etwa 50% der Pulsdauer des Kathodenpulses.

Hierdurch wird begünstigt, dass es nicht zu der Bildung von Bereichen kommt, die unkontrolliert geätzt werden. Ein längerer Passivierpuls stellt sicher, dass die Anzahl der durch den Ätzpuls entstehender Oberflächenatome kleiner ist, als die Anzahl während des Passivierpulses maximal möglich passivierbarer Oberflächenatome.

In einer weiteren vorteilhaften Ausführungsform wird Verfahrensschritt A.1A für eine Zeitdauer größer 45 Minuten durchgeführt, insbesondere für eine Zeitdauer im Bereich 45 Minuten bis 2 Stunden, bevorzugt im Bereich 1 Stunde bis 1,5 Stunden.

Hierdurch bleibt die bereits existierende Schicht weitgehend unverändert und dennoch wird die Dicke der porösen Schicht erhöht.

In einer weiteren vorteilhaften Ausführungsform ist in Verfahrensschritt A.1A die Ätzstromdichte um zumindest 10%, bevorzugt um zumindest 20%, insbesondere um zumindest 35% größer als die Ätzstromdichte in Verfahrensschritt A.1.

Die erhöhte Stromdichte führt zu einer größeren Feldliniendichte, sodass die Entstehung der porösen Schicht vorzugsweise orthogonal zur Substratoberfläche erfolgt.

Vorteilhafterweise wird nach Verfahrensschritt A.3 ein weiterer Ätzschritt A.4 ausgeführt, wobei die Bearbeitungsseite alternierend in einem Anodenpuls als Anode und in einem Kathodenpuls als Kathode polarisiert wird. Hierdurch ergibt sich der Vorteil, dass bei einer evtl. entstehenden Begrenzung der hochporösen Trennschicht durch {111} - Ebenen in Richtung des Festkörpers, die lateral zur Oberfläche stattfindende Diffusion von Atomen behindert werden kann und sich dies nachteilig auf die Bildung der Trennschicht auswirkt. Eine zusätzliche Schicht mit niedrigerer Porosität unterhalb der hochporösen Schicht ermöglicht die Diffusion von Atomen während des Reorganisierens in Verfahrensschritt B aus der hochporösen Schicht und begünstigt so die Entstehung einer Trennschicht.

Ätzschritt A.4 weist bevorzugt eine gegenüber Ätzschritt A.3 geringerer Ätzstromdichte, bevorzugt um zumindest 30%, weiter bevorzugt zumindest 50% geringerer Stromdichte als in Verfahrensschritt A.3 auf. Hierdurch ergibt sich der Vorteil, dass eine Schicht niedrigerer Porosität geschaffen wird, die als Diffusionssenke dient.

Vorteilhafterweise weist Verfahrensschritt A.4 ein asymmetrisches Verhältnis von Kathodenpulsdauer und Anodenpulsdauer auf, insbesondere ein Verhältnis im Bereich von 1,5:1 bis 2,5:1 (Kathodenpulsdauer zu Anodenpulsdauer), insbesondere von 2:1. Hierdurch ergibt sich der Vorteil, dass die bereits existierenden porösen Schichten weiterhin nicht vom Ätzprozess beeinflusst werden.

Das erfindungsgemäße Verfahren ist insbesondere geeignet, um auf dem Germaniumsubstrat an der Bearbeitungsseite eine Halbleiterbauelementschichtstruktur zu erzeugen, welche zumindest eine Schicht aus Germanium umfasst, die bevorzugt epitaktisch abgeschieden, insbesondere mittels Gasphasenepitaxie abgeschieden wird. Die Germaniumschicht weist aufgrund der Präparation der Bearbeitungsseite eine hohe elektronische Güte auf und ist insbesondere zur Ausbildung eines oder mehrerer Halbleiterbauelemente, insbesondere zur Ausbildung einer oder mehrerer photovoltaischer Solarzellen geeignet.

Es liegt im Rahmen der Erfindung, dass die Ausbildung des oder der Halbleiterbauelemente erfolgt, während die Halbleiterbauelementschichtstruktur an dem Germaniumsubstrat angeordnet ist. Ebenso liegt es im Rahmen der Erfindung, dass die Halbleiterbauelementschichtstruktur zunächst von dem Germaniumsubstrat abgelöst wird und anschließend das oder die Halbleiterbauelemente ausgebildet werden, insbesondere mit Ausbildung zusätzlicher Schichten an der Halbleiterbauelementschichtstruktur. Ebenso liegt es im Rahmen der Erfindung, dass das oder die Halbleiterbauelemente teilweise vor Ablösen und teilweise nach Ablösen der Halbleiterbauelementschichtstruktur ausgebildet werden.

Es ist daher vorteilhaft, dass auf die Bearbeitungsseite des Germaniumsubstrats mittelbar oder unmittelbar eine Halbleiterbauelementschichtstruktur aufgebracht wird, wobei die Halbleiterbauelementschichtstruktur zumindest eine erste Schicht aus Germanium oder aus Verbindungshalbleitern mit Elementen der 3. und 5. Hauptgruppe des Periodensystems, aufweist, welche bevorzugt mittels Epitaxie, insbesondere mittels Gasphasenepitaxie aufgebracht wird.

Die erste Schicht aus Germanium oder aus Verbindungshalbleitern mit Elementen der dritten und fünften Hauptgruppe des Periodensystems wird bevorzugt an der Bearbeitungsseite des Germaniumsubstrats, insbesondere bevorzugt unmittelbar an der Bearbeitungsseite des Germaniumsubstrats angeordnet.

Es liegt im Rahmen der Erfindung, dass die Halbleiterbauelementschichtstruktur mehrere Schichten aufweist, insbesondere 2 bis 6 Schichten. Eine solche Halbleiterbauelementschichtstruktur ist insbesondere zur Ausbildung von elektrooptischen Bauelementen, insbesondere photovoltaischen Solarzellen vorteilhaft.

In einer vorteilhaften Ausführungsform besteht daher die erste Schicht der Halbleiterbauelementschichtstruktur aus Germanium und weist eine Dicke von vorzugsweise 1 µm bis 10 µm auf und die Halbleiterbauelementschichtstruktur weist mehrere, vorzugsweise 2 bis 6, Schichten aus Verbindungshalbleitern auf.

Bei einer solchen Halbleiterbauelementschichtstruktur ist eine Dicke der gesamten Halbleiterbauelementschichtstruktur im Bereich 5 µm bis 40 µm vorteilhaft.

In einer weiteren vorteilhaften Ausgestaltung besteht die erste Schicht der Halbleiterbauelementschichtstruktur aus Germanium und weist eine Dicke von 10 bis 150 µm, bevorzugt 50 µm bis 150 µm auf. Eine solche Germaniumschicht ist insbesondere zur Ausbildung von photovoltaischen Solarzellen geeignet.

Die Halbleiterbauelementschichtstruktur wird bevorzugt wie zuvor beschrieben von dem Germaniumsubstrat getrennt.

Es ist daher vorteilhaft, dass die Halbleiterbauelementschichtstruktur von dem Germaniumsubstrat getrennt wird, insbesondere die Ränder der Halbleiterbauelementschichtstruktur entfernt werden, vorzugsweise durch Lasern oder Sägen, bevor die Halbleiterbauelementschichtstruktur von dem Germaniumsubstrat getrennt wird. Ein Abtrennen der Ränder der Halbleiterbauelementschichtstruktur weist den Vorteil auf, dass das Risiko verringert wird, dass die Halbleiterbauelementschichtstruktur beim Abtrennen Schaden nimmt, insbesondere zerbricht.

Das erfindungsgemäße Verfahren weist wie zuvor beschrieben den Vorteil auf, dass das Germaniumsubstrat zur Herstellung mehrerer Germaniumschichten, insbesondere mehrerer Halbleiterbauelementschichtstrukturen verwendet werden kann.

Es ist daher vorteilhaft, dass das Germaniumsubstrat mehrfach verwendet wird, wobei nach Abtrennen der Halbleiterbauelementschichtstruktur als erste Halbleiterbauelementschichtstruktur zumindest eine zweite Halbleiterbauelementschichtstruktur wie zuvor beschrieben auf das Germaniumsubstrat aufgebracht und anschließend von dem Germaniumsubstrat getrennt wird.

Insbesondere ist es vorteilhaft, dass nach Trennen der ersten Halbleiterbauelementschichtstruktur von dem Germaniumsubstrat und vor Aufbringen der zweiten Halbleiterbauelementschichtstruktur die Bearbeitungsseite des Germaniumsubstrats nachbehandelt wird, vorzugsweise mechanisch und/oder chemisch, geglättet wird. Durch die Nachbehandlung wird die Güte der nachfolgend auf dem Germaniumsubstrat erzeugten Schichten erhöht.

Die eingangs genannte Aufgabe ist weiterhin durch eine Germaniumsubstratstruktur gelöst. mit einem Germaniumsubstrat und mit einer epitaktisch auf das Germaniumsubstrat aufgewachsenen Germaniumschicht gelöst.

Eine mit einer bevorzugten Ausführungsform des erfindungsgemäßen Verfahren hergestellte Germaniumsubstratstruktur weist ein Germaniumsubstrat auf, welches mit dem Verfahren, insbesondere einer bevorzugten Ausführungsform hiervon hergestellt ist. Auf dem Germaniumsubstrat der Germaniumsubstratstruktur ist eine Germaniumschicht angeordnet. Das Germaniumsubstrat weist eine als Bearbeitungsseite bezeichnete Vorderseite auf, an welcher die Germaniumschicht angeordnet ist und eine der Vorderseite gegenüberliegende Rückseite.

Die Germaniumschicht weist eine Dotierung des p-Typs oder des n-Typs mit einer Dotierkonzentration größer 10¹⁵ cm⁻³ auf. Das Germaniumsubstrat weist zumindest eine poröse Schicht mit einer Dicke im Bereich 0,1 bis 1,5 µm und einer Porosität größer 40% auf, welche an der Bearbeitungsseite des Germaniumsubstrats angeordnet ist und weist eine das Germaniumsubstrat an der Bearbeitungsseite abschließenden Wachstumsschicht mit einer Dicke im Bereich 1 µm bis 2µm und einer Porosität kleiner 5% auf. Die Germaniumschicht weist an der der porösen Schicht zugewandten Oberfläche eine unregelmäßige, pyramidenförmige Struktur auf. Hierdurch ergeben sich die zuvor genannten Vorteile.

Wie zuvor beschrieben weist Verfahrensschritt A eine Mehrzahl von Bearbeitungsschritten, insbesondere Ätzschritte und/oder Passivierschritte auf, die als elektrochemische Bearbeitungsschritte ausgebildet sind. Hierbei wird bevorzugt die Bearbeitungsseite des Germaniumsubstrats in Kontakt mit einer ersten Ätzlösung gebracht. Die erste Ätzlösung ist bevorzugt mittels einer ersten Elektrode elektrisch kontaktiert. Ein elektrochemisches Ätzen eines Germaniumsubstrats an sich ist bereits bekannt und beispielsweise in "Mesoporous Germanium Formation by Electrochemical Etching" DOI: 10.1149/1.3147271 beschrieben.

Während eines Anodenpulses dient die zu bearbeitende Oberfläche als Anode und nimmt demnach Elektronen von den Ionen des Elektrolyts auf. Während eines Passivierpulses dient die zu bearbeitende Oberfläche als Kathode und gibt Elektronen an die Ionen des Elektrolyts ab.

Die Kontaktierung der Rückseite des Germaniumsubstrats erfolgt bevorzugt, indem die Rückseite mit einer zweiten Ätzlösung in Kontakt gebracht wird, wobei die zweite Ätzlösung mittels einer zweiten Elektrode kontaktiert ist.

Ebenso liegt es im Rahmen der Erfindung, die Kontaktierung der Rückseite des Germaniumsubstrats direkt mit einem elektrisch leitfähigen und festen Medium zu kontaktieren (sogenannter Trockenkontakt).

Mittels einer Spannungsquelle wird ein Potential zwischen erster und zweiter Elektrode erzeugt, so dass ein Ätzstrom fließt.

Die erste und die zweite Ätzflüssigkeit sind bevorzugt physikalisch voneinander getrennt. Insbesondere ist es vorteilhaft, dass erste und zweite Ätzflüssigkeit in zwei Becken angeordnet sind und das Germaniumsubstrat eine Trennwand zwischen den beiden Becken bildet.

Bevorzugt sind erste und zweite Ätzflüssigkeit gleich ausgebildet.

Vorteilhafterweise werden alle Ätzschritte/Passivierungsschritte in Verfahrensschritt A mit den gleichen Ätzflüssigkeiten durchgeführt. Hierdurch ergibt sich ein kostensparender Prozess.

Die erste und/oder die zweite Ätzflüssigkeit weisen bevorzugt eine oder mehrere Säuren, bevorzugt Flusssäure.

Bevorzugt weist die erste und/oder die zweite Ätzflüssigkeit ein Benetzungsmittel, insbesondere Ethanol, Isopropanol, Essigsäure oder Ameisensäure auf.

Bevorzugt weist die erste und/oder die zweite Ätzflüssigkeit Wasser auf.

In einer vorteilhaften Ausführungsform erfolgt der elektrochemische Ätzprozess in einer Anlage welche aus einem Ätzbecken besteht welche an beiden Seiten durch Elektroden kontaktiert ist. Im Ätzbecken befindet sich eine Ätzlösung die aus Flusssäure, einem Benetzungsmittel und Wasser besteht. Der zu ätzende Wafer wird in dem Becken so angeordnet, dass er das Becken in zwei elektrisch voneinander getrennte Bereiche unterteilt. Die Ätz-/Passivierströme werden in einem Generator erzeugt und dieser über elektrischen Leitungen an die beiden Elektroden gebracht.

Vorzugsweise wird durch das Reorganisieren in Verfahrensschritt B eine geschlossene Wachstumsvorlageschicht an der Bearbeitungsseite ausgebildet. Diese weist eine im Wesentlichen geschlossene Oberfläche auf und begünstigt somit ein fehlstellenfreies epitaktisches Aufwachsen einer Halbleiterschicht, insbesondere einer Germaniumschicht, auf der Wachstumsvorlageschicht. Die geschlossene Wachstumsvorlageschicht wird bevorzugt mit einer Dicke im Bereich 1 nm bis 100 nm, insbesondere mit einer Dicke im Bereich 5 nm bis 30 nm ausgebildet.

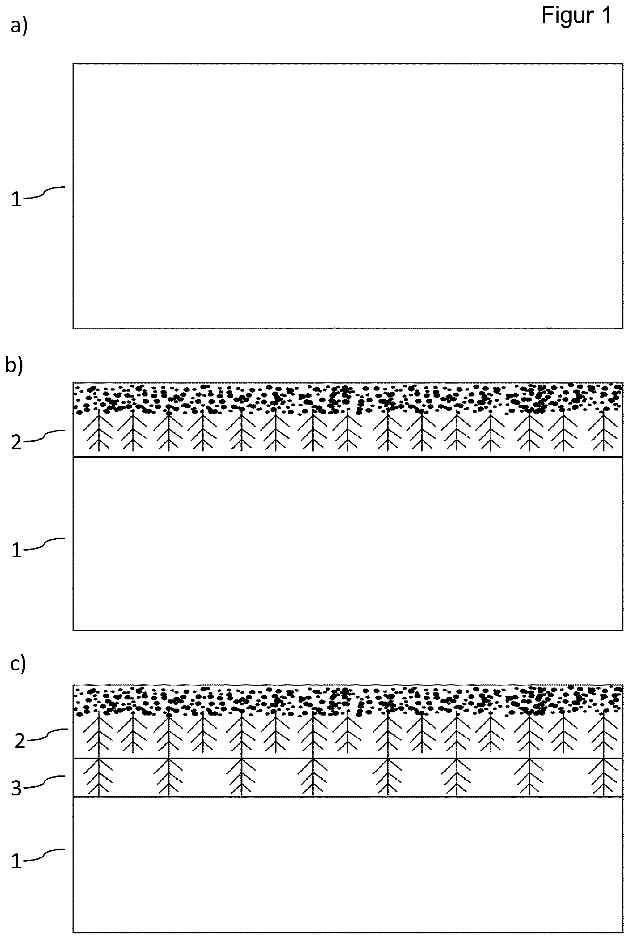

Weitere vorteilhafte Merkmale und Ausführungsformen werden im Folgenden anhand von Ausführungsbeispielen und den Figuren 1 bis 3 erläutert.

Die Figuren zeigen schematische, nicht maßstabsgetreue Darstellungen von Teilschritten eines Ausführungsbeispiels eines erfindungsgemäßen Verfahrens zur Präparation eines Germaniumsubstrats für ein epitaktisches Aufwachsen einer Germaniumschicht.

Zunächst wird ein Germaniumsubstrat bereitgestellt. Bei dem vorliegenden Ausführungsbeispiel weist das Germaniumsubstrat eine Dicke von 170 µm und eine p-Typdotierung mit dem Dotierstoff Ga und einer Dotierkonzentration von (1 bis 2) x 10¹⁸ cm⁻³, vorliegend 1,5 x 10¹⁸ cm⁻³ auf.

Das Germaniumsubstrat wird zumindest an der in den Figuren obenliegenden Bearbeitungsseite (Vorderseite) des Germaniumsubstrats gereinigt, vorliegend mittels Flusssäure in einer Konzentration von einem Gewichtsprozent für eine Zeitdauer von 3 Minuten. In Figur 1a) zeigt schematisch das Germaniumsubstrat 1.

Anschließend erfolgt in einem Verfahrensschritt A ein elektrochemisches Bearbeiten der Bearbeitungsseite des Germaniumsubstrats.

Im vorliegenden Beispiel erfolgt der elektrochemische Ätzprozess in einer Anlage welche aus einem Ätzbecken besteht welche an beiden Seiten durch Elektroden kontaktiert ist. Im Ätzbecken befindet sich eine Ätzlösung die aus Flusssäure, einem Benetzungsmittel und Wasser besteht. Der zu ätzenden Wafer wird in das Becken so eingebaut, dass er das Becken in zwei elektrisch voneinander getrennte Bereiche unterteilt. Die Ätz-/Passivierströme werden in einem Generator erzeugt und dieser über elektrische Leitungen an die beiden Elektroden gebracht.

Die genannten Ätzflüssigkeiten und das beschriebene Verfahren des elektrochemischen Bearbeitens wird für alle nachfolgend beschriebenen Ätzschritte, insbesondere auch für die Passivierungsschritte verwendet.

Der Verfahrensschritt A weist mehrere Teilschritte auf:
In einem Verfahrensschritt A.0 erfolgt eine Passivierung der Bearbeitungsseite des Germaniumsubstrats, wobei die Bearbeitungsseite als Kathode polarisiert wird. Die Passivierung erfolgt für eine Zeitdauer von 20 Sekunden. Die Stromstärke wird hierbei und im Folgenden durch eine Stromdichte angegeben, welche pro Quadratzentimeter der Oberfläche der Bearbeitungsseite des Germaniumsubstrats angegeben wird. In Verfahrensschritt A.0 des vorliegenden ersten Ausführungsbeispiels wird eine Stromstärke j von 1 mA/cm² verwendet.

In einem Verfahrensschritt A.1 erfolgt ein Ätzen der Bearbeitungsseite, wobei die Bearbeitungsseite alternierend mit einem Anodenpuls als Anode und einem Kathodenpuls als Kathode polarisiert wird.

Das Ätzen erfolgt für eine Zeitdauer von insgesamt 30 Minuten bei einer Stromdichte j von 0,75 mA/cm². Alternierend wird die Stromrichtung mit der vorgenannten Stromstärke gewechselt, wobei ein Puls jeweils eine Dauer von 1 Sekunde aufweist und danach unmittelbar die Stromrichtung geändert wird, so dass alternierend für 30 Minuten eine Polarisierung mit abwechselnden Anodenpulsen und Kathodenpulsen von jeweils einer Pulsdauer von 1 Sekunde durchgeführt wird.

Das Ergebnis der Verfahrensschritte A.0 und A.1 ist schematisch in Figur 1b) dargestellt: An der Oberfläche des Germaniumsubstrats 1 wird durch Verfahrensschritt A.1 eine bereichsweise dendritische Schicht 2 ausgebildet, welche vorliegend eine Porosität im Bereich von 1% bis 20%, vorliegend etwa 10 % und eine Dicke von 100 nm bis 1000 nm, vorliegend 500 nm aufweist. Die Schicht 2 weist in einem oberflächennahen Bereich eine schwammartige Struktur und in einem der Rückseite zugewandten Bereich eine dendritische Struktur auf, die in den Figuren schematisch durch Aststrukturen dargestellt ist.

In einem Verfahrensschritt A.1A erfolgt ein Ätzen der Bearbeitungsseite mit einer gegenüber Verfahrensschritt A.1 erhöhten Ätzstromdichte, wobei die Bearbeitungsseite alternierend mit einem Anodenpuls als Anode und einem Kathodenpuls als Kathode polarisiert wird. Dieser Verfahrensschritt wird für eine Zeitdauer von 60 Minuten durchgeführt, bei einer Stromstärke von 1 mA/cm². Bei dem vorliegenden Ausführungsbeispiel erfolgt ein Alternieren mit unterschiedlichen Pulsdauern, wobei sich Anodenpuls und Kathodenpuls alternierend abwechseln, jeder Anodenpuls eine Pulsdauer von 0,5 Sekunden und jeder Kathodenpuls eine Pulsdauer von 1 Sekunde aufweist. Der Zustand nach Verfahrensschritt A.1A ist schematisch in Figur 1c dargestellt:
Während die in Verfahrensschritt A.1 erzeugte Schicht 2 in einem der obenliegenden Bearbeitungsseite des Germaniumsubstrats 1 zugewandten Bereich eine schwammartige, poröse Ausgestaltung zeigt, erstrecken sich in Richtung der Rückseite des Germaniumsubstrats 1 ausgehend von der schwammartigen Schicht astartige poröse Strukturen (dendritischer Bereich) der Schicht 2.

In Verfahrensschritt A.1A wird eine poröse Schicht 3 mit ausgedünnten Ästen erzeugt. Diese poröse Schicht 3 weist vorliegend eine Dicke von 500 nm und eine Porosität im Bereich von 1 % bis 10 % vorliegend 2 % auf. Gegenüber der dendritischen Schicht 2 weist die poröse Schicht 3 mit ausgedünnten Ästen eine geringere Anzahl an astartigen Ausnehmungen auf.

In einem Verfahrensschritt A.2 erfolgt ein Passivieren der Bearbeitungsseite des Germaniumsubstrats 1, wobei die Bearbeitungsseite als Kathode polarisiert wird. Verfahrensschritt A.2 wird für eine Zeitdauer von 10 Minuten bei einer Stromstärke von 1 mA/cm² durchgeführt.

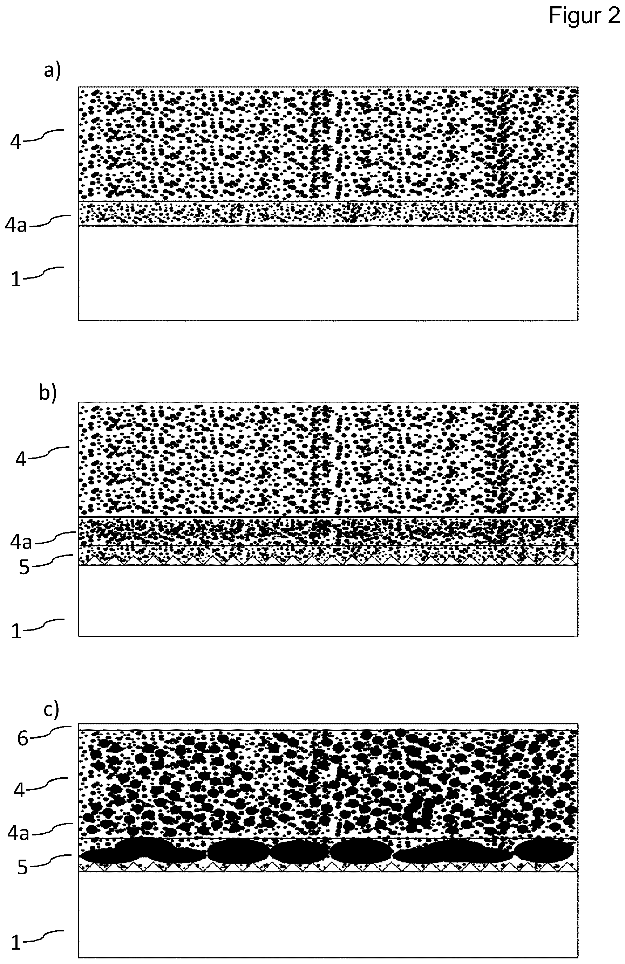

In einem Verfahrensschritt A.3 erfolgt ein Ätzen der Bearbeitungsseite, wobei die Bearbeitungsseite alternierend mit einem Anodenpuls als Anode und einem Kathodenpuls als Kathode polarisiert wird. Vorliegend erfolgt die Behandlung in Verfahrensschritt A.3 für eine Zeitdauer von 45 Minuten, wobei die Stromdichte von Anodenpuls und Kathodenpuls jeweils 4 mA/cm² beträgt, die Pulsdauer der Anodenpulse jeweils 1 Sekunden und die Pulsdauer der Kathodenpulse jeweils 1 Sekunde. Hierdurch erfolgt eine Umwandlung der Aststrukturen in schwammartige, poröse Strukturen, so dass aus der dendritischen Schicht 2 und der porösen Schicht mit ausgedünnten Ästen 3 eine poröse, schwammartige Schicht 4 ausgebildet wird, welche sich zusätzlich um eine poröse schwammartige Schicht 4a weiter in Richtung der Rückseite des Germaniumsubstrats 1 erstreckt. Dies ist schematisch in Figur 2a) dargestellt.

In einem weiteren Verfahrensschritt A.4 erfolgt erneut ein Ätzschritt A.1A: In Verfahrensschritt A.4 wird für eine Zeitdauer von 10 Minuten die Bearbeitungsseite alternierend in einem Anodenpuls als Anode und einem Kathodenpuls als Kathode polarisiert, wobei die Stromdichte bei Anodenpuls und bei Kathodenpuls jeweils 2 mA/cm² beträgt. Die Dauer des Anodenpulses beträgt 0,5 Sekunden und des Kathodenpulses 1 Sekunde.

Hierdurch wird eine dünne poröse Schicht 5 (vorliegend mit einer Dicke von 300 nm) mit Facetten erzeugt, welche den weiter unten beschriebenen Ablösevorgang begünstigen kann. Die Facetten bilden an der der porösen Schicht zugewandten Oberfläche des Germaniumsubstrats eine unregelmäßige, pyramidenförmige Struktur. Dies ist schematisch in Figur 2b) dargestellt.

Darüber hinaus wird die Porosität der Schicht 4a erhöht.

Anschließend erfolgt eine Reinigung des Germaniumsubstrats 1 für 3 Minuten an der Bearbeitungsseite mittels Flusssäure in einer Konzentration eines Gewichtsprozents.

Schließlich wird das Germaniumsubstrat 1 in Ethanol getrocknet.

In einem Verfahrensschritt B erfolgt ein Reorganisieren der Bearbeitungsseite, wobei eine Erwärmung des Germaniumsubstrats auf eine Temperatur größer 500°C erfolgt, vorliegend wird die Temperatur linear mit einer Steigerung von 100°C pro Minute auf 800°C erhöht und anschließend für 30 Minuten bei der Temperatur von 800°C gehalten.

Hierdurch bildet sich an der Vorderseite eine geschlossene Wachstumsvorlageschicht 6 aus. Diese weist vorliegend eine Dicke im Bereich von 100 nm bis 1µm, vorliegend von 100 nm auf.

Darüber hinaus erhöht sich sowohl in den Schichten 4, 4a und die Porosität, wobei die Dicken der Schichten sich etwas verringern und die Kavitäten der Schichten vergrößern.

Auf die geschlossene Wachstumsvorlageschicht 6 kann nun eine Germaniumschicht zur Herstellung eines Halbleiterbauelementes, insbesondere einer photovoltaischen Solarzelle, aufgebracht werden.

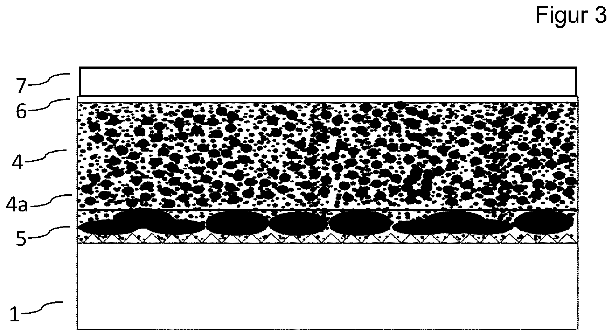

Die Germaniumschicht wird vorliegend mittels Gasphasenepitaxie aufgebracht und weist eine Dicke von 10 µm sowie eine Dotierung von 5x10¹⁷ Atomen/cm³ des p-Typs auf. Dies ist schematisch in Figur 3 dargestellt.

Die Darstellung in Figur 3 zeigt somit ein Ausführungsbeispiel einer erfindungsgemäßen Germaniumsubstratstruktur. Am Übergang zwischen porösem Bereich und dem soliden Halbleiter finden sich pyramidenförmige Struktur die im vorliegenden Querschnittsbild als Facetten ("Sägezahn") erscheinen.

Die Germaniumschicht 7 wird von dem Germaniumsubstrat 1 abgelöst, das Germaniumsubstrat 1 kann durch erneutes Durchführen des Verfahrens wiederverwendet werden, um erneut eine Germaniumschicht epitaktisch abzuscheiden und anschließend abzulösen. Dem Ablösen von Germaniumschicht 7 kann eine Definition der abzulösenden Fläche mittels Sägen oder Lasern vorangehen. Der Ablösevorgang selbst kann durch ein Ansaugen oder Ankleben der abzulösenden Schicht 7 und einem anschließenden mechanischen Abheben erfolgen.

In der folgenden Tabelle sind die wesentlichen Verfahrensparameter der einzelnen Verfahrensschritte nochmals zusammengefasst und zusätzlich auch Verfahrensparameter eines zweiten Ausführungsbeispiels eines erfindungsgemäßen Verfahrens aufgeführt. Die Stromdichte wird hierbei mit j bezeichnet, wobei ein entsprechendes Vorzeichen (+/-) die Stromrichtung angibt. Die Stromdichten werden stets als positive Zahlenwerte angegeben, die Stromrichtung ergibt sich aus dem Vorzeichen der Variable j. Die Pulsdauern der Anodenpulse sind jeweils mit t₊ der Kathodenpulse mit t₋ angegeben. Die Gesamtzeitdauer des Verfahrensschritts ist mit t_{ges} angegeben.

| Verfahrensschritt | Ausführungsbeispiel 1 | Ausführungsbeispiel 2 |
|---|---|---|
| Reinigung | HF, 3min., 1wt% | HF, 3min., 1wt% |
| A.0 | j₋= 1mA/cm² | - |
| | t_{ges} = 20s | |
| A.1 | t₊ = t₋ = 1s | t₊ = t₋ = 1s |
| | j₊=j₋=0,75mA/cm² | j₊=j₋=0,75mA/cm² |
| | t_{ges} = 30 min | t_{ges} = 60 min |
| A.1A | t₊ = 0,5 s | - |
| | t₋ = 1s | |
| | j₊ = j₋ = 1 mA/cm² | |
| | t_{ges} = 60 min | |
| A.2 | j₋= 1mA/cm² | j₋= 1mA/cm² |
| | t_{ges} = 10 min | t_{ges} = 10 min |
| A.3 | t₊ = 1 s | t₊ =0.85 |
| | t₋ = 1s | t₋ = 1s |
| | j₊ = j₋ = 4 mA/cm² | j₊ = j₋ = 5 mA/cm² |
| | t_{ges} = 45 min | t_{ges} = 30 min |
| A.4 | t₊ = 0,5 s | - |
| | t₋ = 1s | |
| | j₊ = j₋ = 2 mA/cm² | |
| | t_{ges} = 10 min | |
| Reinigung | HF, 3min., 1wt% | HF, 3min., 1wt% |
| Trocknung | mittels Ethanol | mittels Ethanol |
| B | Temperaturerhöhung mit | Temperaturerhöhung mit |
| | 100°C/min auf 800°C; 30 min bei 800°C | 100°C/min auf 800°C; 30 min bei 800°C |

Das Ausführungsbeispiel 2 ist eine wesentlich vereinfachte Ausführung im Vergleich zu Beispiel 1. Sie unterscheidet sich insofern von Beispiel 1, als dass keine initiale Passivierung der Waferoberfläche (Verfahrensschritt A.0) vor dem ersten Ätzschritt erfolgt was zu einer geringeren Homogenität des Ätzangriffes führen kann. Anschließend an den ersten Ätzschritt erfolgt in Beispiel 2 kein weiterer Ätzschritt mit angepassten Ätzparametern was zu einem Ausbleiben eines ausgedünnten Schichtbereichs an der Grenzfläche zum soliden Wafer führen kann (siehe Schicht 3 in Fig.1 c). Weiterhin fehlt in Beispiel 2 der finale elektrochemische Ätzschritt was zu einer weniger stark ausgeprägten hochporösen Schicht an der Grenze zum soliden Wafer und zu einer weniger stark ausgeprägten Facettierung an diese Grenzfläche führen kann.

### Bezugszeichenliste

- 1: Germaniumsubstrat
- 2: dendritische Schicht
- 3: poröse Schicht mit ausgedünnten Ästen
- 4, 4a: poröse, schwammartige Schicht
- 6: geschlossene Wachstumsvorlageschicht
- 7: epitaktisch aufgebrachte Germaniumschicht

## Patentansprüche

1. Verfahren zur Präparation eines Germaniumsubstrats (1) für ein epitaktisches Aufwachsen einer Germaniumschicht (7),
mit den Verfahrensschritten:
A. Bereitstellen eines Germaniumsubstrats (1) mit einer Bearbeitungsseite und einer der Bearbeitungsseite gegenüberliegenden Rückseite und elektrochemisches Bearbeiten zumindest der Bearbeitungsseite des Germaniumsubstrats (1) mit zumindest den Bearbeitungsschritten:
A.0 Passivierung der Bearbeitungsseite, wobei die Bearbeitungsseite als Kathode polarisiert wird,
A.1 Ätzen der Bearbeitungsseite, wobei die Bearbeitungsseite alternierend in einem Anodenpuls als Anode und in einem Kathodenpuls als Kathode polarisiert wird,
A.2 Elektrochemisches Passivieren der Bearbeitungsseite des Germaniumsubstrats (1),
wobei die Bearbeitungsseite als Kathode polarisiert wird;
A.3 Ätzen der Bearbeitungsseite, wobei die Bearbeitungsseite alternierend in einem Anodenpuls als Anode und in einem Kathodenpuls als Kathode polarisiert wird;
B Reorganisieren der Bearbeitungsseite, wobei eine Erwärmung des Germaniumsubstrats (1) auf eine Temperatur größer 500°C erfolgt;
wobei
die Verfahrensschritte in der aufgeführten Reihenfolge durchgeführt werden, und wobei
in Verfahrensschritt A.1 die Ätzstromdichte des Anoden- und Kathodenpulses im Bereich 0,1 mA/cm² bis 1 mA/cm² liegt,
der Verfahrensschritt A.1 für eine Zeitdauer im Bereich 15 Minuten bis 2 Stunden durchgeführt wird und wobei
in Verfahrensschritt A.3 die Ätzstromdichte des Anoden- und Kathodenpulses im Bereich 2 mA/cm² bis 15 mA/cm² liegt, Verfahrensschritt A.3 für eine Zeitdauer im Bereich 3 Minuten bis 1 Stunde durchgeführt wird,
in Verfahrensschritt A.3 die Dauer des Anodenpulses kürzer als die Dauer des Kathodenpulses ist und wobei
in Verfahrensschritt A.1 und A.3 die Pulsdauer jeweils kleiner 10 Sekunden ist.

2. Verfahren nach Anspruch 1,
wobei mittels Verfahrensschritt A.1 eine dendritische Schicht (2), bevorzugt mit einer Porosität im Bereich 5% bis 15% und einer Dicke im Bereich 200 nm bis 1,5 µm an der Bearbeitungsseite erzeugt wird.

3. Verfahren nach einem der vorangegangenen Ansprüche,
wobei Verfahrensschritt A.2 für eine Zeitdauer im Bereich 5 Minuten bis 20 Minuten, insbesondere im Bereich 4 Minuten bis 12 Minuten durchgeführt wird.

4. Verfahren nach einem der vorangegangenen Ansprüche,
wobei in Verfahrensschritt B eine Erwärmung auf eine Temperatur im Bereich 600°C bis 800°C erfolgt und/oder die Erwärmung für eine Zeitdauer größer oder gleich 15 Minuten, insbesondere im Bereich 15 Minuten bis 1,5h erfolgt und/oder dass Verfahrensschritt B in einer Wasserstoffatmosphäre oder Argonatmosphäre durchgeführt wird.

5. Verfahren nach einem der vorangegangenen Ansprüche,
wobei Verfahrensschritt A.0 und/oder Verfahrensschritt A.2, bevorzugt Verfahrensschritt A.0 und Verfahrensschritt A.2 für eine Zeitdauer größer 10 Sekunden, insbesondere größer 15 Sekunden, bevorzugt größer 20 Sekunden durchgeführt wird, insbesondere,
dass Verfahrensschritt A.0 für eine Zeitdauer im Bereich 10 Sekunden bis 30 Sekunden, insbesondere im Bereich 15 Sekunden bis 25 Sekunden durchgeführt wird.

6. Verfahren nach einem der vorangegangenen Ansprüche,
wobei zwischen Verfahrensschritt A.1 und A.2 in einem Verfahrensschritt A.1A ein Ätzen der Bearbeitungsseite mit einer gegenüber Verfahrensschritt A.1 erhöhten Ätzstromdichte erfolgt, wobei die Bearbeitungsseite alternierend in einem Anodenpuls als Anode und in einem Kathodenpuls als Kathode polarisiert wird,
und die Anodenpulsdauer kürzer als die Kathodenpulsdauer ist.

7. Verfahren nach Anspruch 6,
wobei mittels Verfahrensschritt A.1A eine Schicht mit einer Dicke im Bereich 0,5 µm bis 2 µm, insbesondere im Bereich 1,4 µm bis 1,6 µm und einer Porosität im Bereich 5% bis 15% erzeugt wird.

8. Verfahren nach einem der Ansprüche 6 bis 7,
wobei in Verfahrensschritt A.1A die Pulsdauer des Kathodenpulses im Bereich 30% bis 70%, bevorzugt im Bereich 40% bis 60%, insbesondere etwa 50% der Pulsdauer des Anodenpulses beträgt.

9. Verfahren nach einem der Ansprüche 6 bis 8,
wobei Verfahrensschritt A.1A für eine Zeitdauer größer 45 Minuten durchgeführt wird, insbesondere für eine Zeitdauer im Bereich 45 Minuten bis 2 Stunden, bevorzugt im Bereich 1 Stunde bis 1,5 Stunden.

10. Verfahren nach einem der Ansprüche 6 bis 9,
wobei in Verfahrensschritt A.1A die Ätzstromdichte um zumindest 10%, bevorzugt um zumindest 20%, insbesondere um zumindest 35% größer ist als die Ätzstromdichte in Verfahrensschritt A.1.

11. Verfahren nach einem der vorangegangenen Ansprüche,
wobei nach Verfahrensschritt A.3 in einem Verfahrensschritt A.4 ein Ätzen der Bearbeitungsseite erfolgt, wobei die Bearbeitungsseite alternierend in einem Anodenpuls als Anode und in einem Kathodenpuls als Kathode polarisiert wird und die Anodenpulsdauer länger als die Kathodenpulsdauer ist.

12. Verfahren nach einem der vorangegangenen Ansprüche, wobei auf die Bearbeitungsseite des Germaniumsubstrats (1) mittelbar oder unmittelbar eine Halbleiterbauelementschichtstruktur aufgebracht wird, wobei die Halbleiterbauelementschichtstruktur zumindest eine erste Schicht aus Germanium oder aus Verbindungshalbleitern mit Elementen der 3. und 5. Hauptgruppe des Periodensystems, aufweist, welche bevorzugt mittels Epitaxie, insbesondere mittels Gasphasenepitaxie aufgebracht wird.

13. Verfahren nach Anspruch 12, wobei
(i) die erste Schicht der Halbleiterbauelementschichtstruktur aus Germanium besteht und eine Dicke von vorzugsweise 1 bis 10 µm aufweist und die Halbleiterbauelementschichtstruktur mehrere, vorzugsweise 2 bis 6, Schichten aus Verbindungshalbleitern aufweist,
wobei die Halbleiterbauelementschichtstruktur bevorzugt insgesamt eine Dicke im Bereich 5 µm bis 40 µm aufweist,
oder
(ii) die erste Schicht der Halbleiterbauelementschichtstruktur aus Germanium besteht und eine Dicke von 10 bis 150 µm, bevorzugt 50 µm bis 150 µm aufweist.

14. Verfahren nach einem der vorausgegangenen Ansprüche 12 bis 13 wobei die Halbleiterbauelementschichtstruktur von dem Germaniumsubstrat (1) getrennt wird, insbesondere die Ränder der Halbleiterbauelementschichtstruktur entfernt werden, vorzugsweise durch Lasern oder Sägen, bevor die Halbleiterbauelementschichtstruktur von dem Germaniumsubstrat (1) getrennt wird.

15. Verfahren nach einem der vorausgegangenen Ansprüche 12 bis 14, wobei das Germaniumsubstrat (1) mehrfach verwendet wird, wobei nach Abtrennen der Halbleiterbauelementschichtstruktur als erste Halbleiterbauelementschichtstruktur zumindest eine zweite Halbleiterbauelementschichtstruktur gemäß Anspruch 9 auf das Germaniumsubstrat (1) aufgebracht und anschließend von dem Germaniumsubstrat (1) getrennt wird,
insbesondere, wobei nach Trennen der ersten Halbleiterbauelementschichtstruktur von dem Germaniumsubstrat (1) und vor Aufbringen der zweiten Halbleiterbauelementschichtstruktur die Bearbeitungsseite des Germaniumsubstrats (1) nachbehandelt wird, vorzugsweise mechanisch und/oder chemisch, geglättet wird.

## Claims

1. A method for preparing a germanium substrate (1) for the epitaxial growth of a germanium layer (7),
comprising the steps:
A. providing a germanium substrate (1) having a processing side and a back side opposite the processing side, and electrochemically processing at least the processing side of the germanium substrate (1) using at least the following processing steps:
A.0 passivating the processing side, wherein the processing side is polarized as a cathode,
A.1 etching the processing side, wherein the processing side is alternately polarized as an anode in an anode pulse and as a cathode in a cathode pulse,
A.2 electrochemically passivating the processing side of the germanium substrate (1), wherein the processing side is polarized as a cathode;
A.3 etching the processing side, wherein the processing side is alternately polarized as an anode in an anode pulse and as a cathode in a cathode pulse;
B reorganizing the processing side, wherein a heating of the germanium substrate (1) takes place at a temperature greater than 500°c;
wherein the steps are carried out in the order listed, and wherein, in step A.1, the etching current density of the anode and cathode pulses is in the range from 0.1 mA/cm² to 1 mA/cm²,
step A.1 is carried out for a duration in the range from 15 minutes to 2 hours, and wherein in step A.3, the etching current density of the anode and cathode pulses is in the range from 2 mA/cm² to 15 mA/cm²,
step A.3 is carried out for a duration in the range from 3 minutes to 1 hour,
in step A.3, the duration of the anode pulse is shorter than the duration of the cathode pulse, and wherein
in steps A.1 and A.3, the pulse duration is respectively less than 10 seconds.

2. The method according to claim 1,
wherein, by means of step A.1, a dendritic layer (2), preferably having a porosity in the range from 5% to 15% and a thickness in the range from 200 nm to 1.5 µm, is formed on the processing side.

3. The method according to any one of the preceding claims,
wherein step A.2 is carried out for a duration in the range from 5 to 20 minutes, in particular in the range from 4 to 12 minutes.

4. The method according to any one of the preceding claims,
wherein, in step B, heating takes place at a temperature in the range from 600°C to 800°C and/or the heating takes place for a duration greater than or equal to 15 minutes, in particular in the range from 15 minutes to 1.5 hours, and/or in that step B is carried out in a hydrogen atmosphere or an argon atmosphere.

5. The method according to any one of the preceding claims,
wherein step A.0 and/or step A.2, preferably step A.0 and step A.2, is carried out for a duration greater than 10 seconds, in particular greater than 15 seconds, preferably greater than 20 seconds, in particular,
in that step A.0 is carried out for a duration in the range from 10 seconds to 30 seconds, in particular in the range from 15 seconds to 25 seconds.

6. The method according to any one of the preceding claims,
wherein, between steps A.1 and A.2, in a step A.1 A, etching of the processing side takes place with an etching current density higher than that in step A.1, wherein the processing side is alternately polarized as an anode in an anode pulse and as a cathode in a cathode pulse,
and the anode pulse duration is shorter than the cathode pulse duration.

7. The method according to claim 6,
wherein, by means of step A.1A, a layer with a thickness in the range from 0.5 µm to 2 µm, in particular, in the range from 1.4 µm to 1.6 µm, and a porosity in the range from 5% to 15% is formed.

8. The method according to any one of claims 6 to 7,
wherein, in step A.1A, the pulse duration of the cathode pulse is in the range from 30% to 70%, preferably in the range from 40% to 60%, and in particular approximately 50% of the pulse duration of the anode pulse.

9. The method according to any one of claims 6 to 8,
wherein step A.1A is carried out for a duration greater than 45 minutes, in particular for a duration in the range from 45 minutes to 2 hours, preferably in the range from 1 hour to 1.5 hours.

10. The method according to any one of claims 6 to 9,
wherein, in step A.1A, the etching current density is at least 10%, preferably at least 20%, and in particular at least 35%, greater than the etching current density in step A.1.

11. The method according to any one of the preceding claims,
wherein, following step A.3, in a step A.4, etching of the processing side takes place, wherein the processing side is alternately polarized as an anode in an anode pulse and as a cathode in a cathode pulse, and the anode pulse duration is longer than the cathode pulse duration.

12. The method according to any one of the preceding claims, wherein a semiconductor device layer structure is deposited, directly or indirectly, onto the processing side of the germanium substrate (1),
wherein the semiconductor device layer structure comprises at least a first layer of germanium or of compound semiconductors containing elements of main groups 3 and 5 of the periodic table, which is preferably deposited by epitaxy, in particular by gas-phase epitaxy.

13. The method according to claim 12, wherein
(i) the first layer of the semiconductor device layer structure consists of germanium and has a thickness of preferably 1 to 10 µm, and the semiconductor device layer structure comprises multiple, preferably 2 to 6, layers of compound semiconductors,
wherein the semiconductor device layer structure preferably has a total thickness in the range from 5 µm to 40 µm,
or
(ii) the first layer of the semiconductor device layer structure consists of germanium and has a thickness from 10 to 150 µm, preferably 50 µm to 150 µm.

14. The method according to any one of the preceding claims 12 to 13, wherein the semiconductor device layer structure is separated from the germanium substrate (1), in particular the edges of the semiconductor device layer structure are removed, preferably by laser cutting or sawing, before the semiconductor device layer structure is separated from the germanium substrate (1).

15. The method according to any one of the preceding claims 12 to 14,
wherein the germanium substrate (1) is used multiple times, wherein, after the first semiconductor device layer structure has been separated as the first semiconductor device layer structure, at least one second semiconductor device layer structure according to claim 9 is deposited onto the germanium substrate (1) and subsequently separated from the germanium substrate (1),
in particular, wherein, after separating the first semiconductor device layer structure from the germanium substrate (1) and before the second semiconductor device layer structure is deposited, the processing side of the germanium substrate (1) is subjected to post-processing, preferably to mechanical and/or chemical smoothing.

## Revendications

1. Procédé de préparation d'un substrat de germanium (1) pour une croissance épitaxiale d'une couche de germanium (7)
comprenant les étapes de procédé suivantes :
A. Fourniture d'un substrat de germanium (1) comportant une face de traitement et une face arrière opposée à la face de traitement, et traitement électrochimique d'au moins la face de traitement du substrat de germanium (1) comprenant au moins les étapes de traitement suivantes :
A. 0 Passivation de la face de traitement, dans lequel la face de traitement est polarisée en tant que cathode,
A. 1 Gravure de la face de traitement, dans lequel la face de traitement est polarisée alternativement en tant qu'anode lors d'une impulsion anodique et en tant que cathode lors d'une impulsion cathodique,
A. 2 Passivation électrochimique de la face de traitement du substrat de germanium (1), dans lequel la face de traitement est polarisée en tant que cathode ;
A. 3 Gravure de la face de traitement, dans lequel la face de traitement est polarisée alternativement en tant qu'anode lors d'une impulsion anodique et en tant que cathode lors d'une impulsion cathodique ;
B Réorganisation de la face de traitement, dans lequel un chauffage du substrat de germanium (1) est effectué à une température supérieure à 500°C ;
dans lequel les étapes de procédé sont réalisées dans l'ordre mentionné, et dans lequel, à l'étape de procédé A. 1, la densité de courant de gravure de l'impulsion anodique et de l'impulsion cathodique se situe dans la plage allant de 0,1 mA/cm² à 1 mA/cm²,
l'étape de procédé A. 1 est réalisée pendant une durée comprise dans la plage allant de 15 minutes à 2 heures, et dans lequel, à l'étape de procédé A. 3, la densité de courant de gravure de l'impulsion anodique et de l'impulsion cathodique se situe dans la plage allant de 2 mA/cm² à 15 mA/cm²,
l'étape de procédé A. 3 est réalisée pendant une durée comprise dans la plage allant de 3 minutes à 1 heure,
à l'étape de procédé A. 3, la durée de l'impulsion anodique est plus courte que la durée de l'impulsion cathodique et dans lequel
à l'étape de procédé A. 1 et A. 3, la durée d'impulsion est respectivement inférieure à 10 secondes.

2. Procédé selon la revendication 1,
dans lequel, au moyen de l'étape de procédé A. 1, une couche dendritique (2) présentant de préférence une porosité dans la plage allant de 5 % à 15 % et une épaisseur dans la plage allant de 200 nm à 1,5 µm est produite au niveau de la face de traitement.

3. Procédé selon l'une quelconque des revendications précédentes,
dans lequel l'étape de procédé A. 2 est réalisée pendant une durée comprise dans la plage allant de 5 minutes à 20 minutes, en particulier dans la plage allant de 4 minutes à 12 minutes.

4. Procédé selon l'une quelconque des revendications précédentes,
dans lequel, à l'étape de procédé B, un chauffage à une température dans la plage allant de 600°C à 800°C est effectué et/ou le chauffage est effectué pendant une durée supérieure ou égale à 15 minutes, en particulier dans la plage allant de 15 minutes à 1,5 h, et/ou l'étape de procédé B est réalisée dans une atmosphère d'hydrogène ou une atmosphère d'argon.

5. Procédé selon l'une quelconque des revendications précédentes,
dans lequel l'étape de procédé A. 0 et/ou l'étape de procédé A. 2, de préférence l'étape de procédé A. 0 et l'étape de procédé A. 2, sont réalisées pendant une durée supérieure à 10 secondes, en particulier supérieure à 15 secondes, de préférence supérieure à 20 secondes, en particulier,
l'étape de procédé A. 0 est réalisée pendant une durée comprise dans la plage allant de 10 secondes à 30 secondes, en particulier dans la plage allant de 15 secondes à 25 secondes.

6. Procédé selon l'une quelconque des revendications précédentes,
dans lequel entre les étapes de procédé A. 1 et A. 2, une gravure de la face de traitement est effectuée, dans une étape de procédé A. 1A, avec une densité de courant de gravure accrue par rapport à l'étape de procédé A. 1, dans lequel la face de traitement est polarisée alternativement en tant qu'anode lors d'une impulsion anodique et en tant que cathode lors d'une impulsion cathodique,
et la durée d'impulsion anodique est plus courte que la durée d'impulsion cathodique.

7. Procédé selon la revendication 6,
dans lequel, au moyen de l'étape de procédé A. 1A, une couche présentant une épaisseur dans la plage allant de 0,5 µm à 2 µm, en particulier dans la plage allant de 1,4 µm à 1,6 µm et une porosité dans la plage allant de 5 % à 15 %, est produite.

8. Procédé selon l'une quelconque des revendications 6 à 7,
dans lequel, dans l'étape de procédé A. 1A, la durée d'impulsion de l'impulsion cathodique dans la plage allant de 30 % à 70 %, de préférence dans la plage allant de 40 % à 60 %, représente en particulier environ 50 % de la durée d'impulsion de l'impulsion anodique.

9. Procédé selon l'une quelconque des revendications 6 à 8,
dans lequel l'étape de procédé A. 1A est réalisée pendant une durée supérieure à 45 minutes, en particulier pendant une durée dans la plage allant de 45 minutes à 2 heures, de préférence dans la plage allant de 1 heure à 1,5 heure.

10. Procédé selon l'une quelconque des revendications 6 à 9,
dans lequel, dans l'étape de procédé A. 1A, la densité de courant de gravure est supérieure d'au moins 10 %, de préférence d'au moins 20 %, en particulier d'au moins 35 %, à la densité de courant de gravure de l'étape de procédé A. 1.

11. Procédé selon l'une quelconque des revendications précédentes,
dans lequel, après l'étape de procédé A. 3, une gravure de la face de traitement est effectuée dans une étape de procédé A. 4, dans lequel la face de traitement est polarisée alternativement en tant qu'anode lors d'une impulsion anodique et en tant que cathode lors d'une impulsion cathodique, et la durée d'impulsion anodique est plus longue que la durée d'impulsion cathodique.

12. Procédé selon l'une quelconque des revendications précédentes, dans lequel une structure en couches de composants semi-conducteurs est appliquée directement ou indirectement sur la face de traitement du substrat de germanium (1),
dans lequel la structure en couches de composants semi-conducteurs présente au moins une première couche en germanium ou en semi-conducteurs composés à base d'éléments des 3e et 5e groupes principaux du tableau périodique, laquelle couche est appliquée de préférence par épitaxie, en particulier par épitaxie en phase vapeur.

13. Procédé selon la revendication 12, dans lequel
(i) la première couche de la structure en couches de composants semi-conducteurs est constituée de germanium et présente une épaisseur allant de préférence de 1 à 10 µm, et la structure en couches de composants semi-conducteurs présente plusieurs couches, de préférence 2 à 6 couches, en semi-conducteurs composés,
dans lequel la structure en couches de composants semi-conducteurs présente de préférence une épaisseur totale comprise dans la plage allant de 5 µm à 40 µm,
ou
(ii) la première couche de la structure en couches de composants semi-conducteurs est constituée de germanium et présente une épaisseur allant de 10 à 150 µm, de préférence allant de 50 µm à 150 µm.

14. Procédé selon l'une quelconque des revendications précédentes 12 à 13, dans lequel la structure en couches de composants semi-conducteurs est séparée du substrat de germanium (1), en particulier les bords de la structure en couches de composants semi-conducteurs sont retirés, de préférence par laser ou sciage, avant que la structure en couches de composants semi-conducteurs ne soit séparée du substrat de germanium (1).

15. Procédé selon l'une quelconque des revendications précédentes 12 à 14,
dans lequel le substrat de germanium (1) est utilisé plusieurs fois, dans lequel, après séparation de la structure en couches de composants semi-conducteurs en tant que première structure en couches de composants semi-conducteurs, au moins une seconde structure en couches de composants semi-conducteurs selon la revendication 9 est appliquée sur le substrat de germanium (1) et ensuite séparée du substrat de germanium (1),
en particulier, dans lequel après séparation de la première structure en couches de composants semi-conducteurs du substrat de germanium (1) et avant l'application de la seconde structure en couches de composants semi-conducteurs, la face de traitement du substrat de germanium (1) est soumise à un post-traitement, de préférence mécaniquement et/ou chimiquement lissée.
